# EUROPEAN PATENT APPLICATION

(11) **EP 2 830 103 A1**
(43) Date of publication of application: **28.01.2015**
(21) Application number: 13868999.7
(22) Date of filing: 27.06.2013
(51) Int. Cl.: H01L 31/052, H01L 31/18

(54) **POCKET TYPE PHOTOVOLTAIC POWER GENERATION BACK SHEET, METHOD FOR MANUFACTURING SAID BACK SHEET, AND PHOTOVOLTAIC POWER GENERATION MODULE INCLUDING SAID BACK SHEET**

(30) Priority: 27.12.2012 KR 20120154597; 27.12.2012 KR 20120154598
(71) Applicant: Kim, Min Hyuk, Gyeonggi-do 463-400 (KR)
(72) Inventor: Kim, Min Hyuk, Gyeonggi-do 463-400 (KR)
(74) Representative: Schaumburg, Thoenes, Thurn, Landskron, Eckert
(86) International application number: PCT/KR2013/005718
(87) International publication number: WO 2014/104506

(57) **Abstract**

The present invention includes: a step for forming a heat radiating or weather resistant coating layer on an exposed surface of an insulating film; a step for bringing the insulating film into close contact with both surfaces of a plate-shaped heat conduction member; and a step for then forming an externally blocked pocket by sealing an opening portion of the insulating film to seal a back sheet, that is, the heat conduction member. Accordingly, the penetration of the back sheet by moisture or foreign substances can be prevented, the insulating performance of the back sheet can be improved, and the size of the heat conduction member and the size of the insulating film can be designed without restriction. In this manner, a path can be provided such that gas generated in an EVA layer in a photovoltaic module and the problem of back sheet peeling are completely addressed. The back sheet that is provided is capable of improving the safety and quality of the back sheet itself and the safety and quality of the photovoltaic module.

## Description

### Field of the Invention

The present invention relates to a fabrication method of a pocket-type photovoltaic backsheet and a pocket-type photovoltaic backsheet fabricated by the same, and a photovoltaic module equipped with the backsheet,

and, more particularly, by performing a process of forming a coating layer having properties of thermal conduction, radiation, and durability (or weather resistance) on an exposed surface of an insulation film, a process of adhering the insulation film on both sides of a plate-like thermal conductive member, and, thereafter, a process of sealing an opening of the insulation film, so as to form a pocket blocking an outside environment,

by sealing the backsheet, *i.e.,* the thermal conductive member, humidity or other impurities (or foreign materials) may be prevented from being introduced to the backsheet (in other words, a laminated surface between the thermal conductive member and the insulation film is not exposed to the outside (or outside environment), and, thereby preventing any peeling of the thermal conductive member and the insulation film caused by any contact with humidity, and so on), and by sealing the exposure of the side surface of the thermal conductive member of the related art by using the insulation film, the insulation performance of the backsheet may be upgraded to a higher level, and, furthermore, when fabricating the photovoltaic module by using the conventional method by using a thermal conductive member formed of a metallic or graphite material, through which gas cannot be transmitted (or penetrated), without any edge, since the photovoltaic module is installed on the outside, and since gas that is generated from an EVA layer of the module cannot be discharged to the outside, in the long term, a critical downside of other layers of the photovoltaic module and the backsheet being inevitably peeled may occur, however, in the backsheet according to the present invention, since a size of the thermal conductive member and a size of the insulation film can be easily and freely designed, by providing diverse forms of paths enabling gas, which is generated from the EVA layer within the photovoltaic module, to be discharged, the problem of the peeling of the backsheet is completely resolved, and, eventually, the present invention relates to providing a backsheet that can enhance safety and quality of the backsheet itself and that can enhance safety and quality of the photovoltaic module, and to providing a photovoltaic module using the same.

### Background Art

As a related art heat radiating sheet or backsheet, Patent Registration No. 10-0962642 (2010.06.11. This will hereinafter be referred to as 'related art'.) "Photo voltaic module with heat radiating sheet coating ceramic" is disclosed.

In the related art, the heat radiating sheet is configured of a laminated structure by an order of a glass substrate, a front-surface solar EVA, a solar cell, a rear-surface solar EVA, and a heat radiating sheet having a ceramic coating layer formed thereon, and is formed of a material having excellent thermal conductivity, which is selected from one of aluminum, copper, brass, steel plate, stainless, and a metallic thin plate having an emissivity performance that is equivalent to or greater than the above-mentioned materials,

additionally, by forming the ceramic coating layer as a thermal conductive ceramic coating layer by performing ceramic coating on one surface or both surfaces of a heat radiating sheet using a general ceramic coating method, an object is to enhance heat radiation and to enhance power generating efficiency of the module by enhancing heat radiation.

However, in the related art, since the side surface of the heat radiating sheet is exposed to the outside, introduction of humidity, dust or other impurities between each member cannot be prevented, and

additionally, since the side surface of the heat radiating sheet is always likely to be in contact with ambient air or humidity, a problem of each film or sheet-type lamination being peeled may occur.

Furthermore, in the related art, since a metallic thin film is always exposed along the four edges of an external sheet, electricity being generated by a solar cell may leak through an exposed part, a problem of degradation in the insulation performance may occur, and accordingly, a critical problem of being incapable of ensuring safety of the photovoltaic device (or photovoltaic power generating device) may occur.

### Detailed Description of the Invention

### Technical Objects

The present invention is devised to resolve the above-described drawbacks and problems of the related art backsheet,

by providing a pocket-type backsheet having a thermal conductive member sealed therein by performing a process of forming a coating layer having properties of thermal conduction, radiation, and durability (or weather resistance) on an exposed surface of an insulation film, a process of adhering the insulation film on both sides of a plate-like thermal conductive member, and, thereafter, a process of sealing an opening of the insulation film, so as to form a pocket blocking an outside environment,

since the laminated surface between the thermal conductive member and the insulation film is not exposed to the outside environment, any peeling of the thermal conductive member and the insulation film caused by contact with ambient air or humidity may be prevented, and, in the end, introduction of humidity or impurities in the backsheet may be blocked, and

additionally, although, in the related art, the side surface of the thermal conductive member is exposed to an aluminum frame of the photovoltaic module, thereby causing leakage current, in the present invention, by sealing the thermal conductive member by using the insulation film, so as to block out all external contact, not only can the insulation performance of the backsheet be upgraded to a higher level,

when fabricating the photovoltaic module by using the conventional method by using a thermal conductive member formed of a metallic or graphite material, through which gas cannot be transmitted (or penetrated), without any edge, since the photovoltaic module is installed on the outside, and since gas that is generated from an EVA layer of the module cannot be discharged to the outside, in the long term, a critical downside of other layers of the photovoltaic module and the backsheet being inevitably peeled may occur, however, in order to resolve such problem, an object of the present invention is to freely design a size of the thermal conductive member and a size of the insulation film and, accordingly, to freely design a size of a gap (or aperture) formed between the thermal conductive member and a size of the insulation film, so as to provide diverse forms of paths enabling gas, which is generated from the EVA layer within the photovoltaic module, to be discharged, thereby providing a backsheet that can completely resolve the problem of the peeling of the backsheet, and

eventually, an object of the present invention is to enhance the safety and quality of the backsheet itself, and to enhance the safety and quality of the photovoltaic module, which is equipped with the corresponding backsheet, and

furthermore, another object of the present invention is to simplify the fabrication process of the pocket-type backsheet, so as to enable mass production to be realized, thereby increasing productivity, and, by reducing the fabrication cost accordingly, economic feasibility may also be increased.

### Technical Solutions

A fabrication method of a pocket-type photovoltaic backsheet according to the present invention includes
(a) a step of forming a coating layer having one or more functions selected from thermal conduction, radiation, and durability (or weather resistance) on a portion of an exposed surface or an entire exposed surface of an insulation film,
(b) a step of adhering the insulation film having a size that is larger than a thermal conductive member on both sides of a plate-like thermal conductive member, and
(c) a step of sealing an opening of the insulation film, wherein the opening is formed by placing the insulation film having a size larger than the thermal conductive member on both sides of the thermal conductive member, so as to form a pocket blocking an outside environment.

Additionally, the adhesion of the thermal conductive member and the insulation film of the (b) step is performed by an adhesion means.

Additionally, after the (b) step, a heat radiation ceramic layer or a heat radiation coating layer is further formed on an exposed surface of the coating layer,
or, after the (b) step, a protection layer is further formed on an exposed surface of the coating layer.

Furthermore, a backsheet according to the present invention includes
an insulation film,
a coating layer having one or more functions selected from thermal conduction, radiation, and durability (or weather resistance) formed on a portion of an exposed surface or an entire exposed surface of the insulation film, and
a plate-like thermal conductive member being adhered to both sides of the insulation film,
wherein the insulation film is formed to have a size larger than the thermal conductive member, and wherein an opening of the insulation film, which is formed accordingly, is sealed, so as to form a pocket blocking an outside environment.

### Effects of the Invention

The fabrication method of a pocket-type photovoltaic backsheet and a pocket-type photovoltaic backsheet fabricated by the same, and a photovoltaic module equipped with the backsheet according to the present invention,
may block humidity or impurities from being introduced inside the backsheet, by sealing the opening of the insulation film, so as to form a pocket blocking the outside environment and sealing the backsheet, and, additionally, the present invention may prevent any peeling of the thermal conductive member and the insulation film, which is caused by contact with ambient air or humidity, from occurring, since the laminated surface between the thermal conductive member and the insulation film is not exposed to the outside environment.

Furthermore, although, in the related art, the side surface of the thermal conductive member was exposed to a frame of the photovoltaic module, by sealing the thermal conductive member by using the insulation film, so as to block out all external contact, the present invention can not only upgrade the insulation performance of the backsheet to a higher level but can also enhance the safety and product quality of the photovoltaic module product in accordance with such upgrade.

Furthermore, in the present invention, since the fabrication process of the pocket-type backsheet is simplified, mass production may be realized, thereby increasing productivity, and by reducing the fabrication cost accordingly, economic feasibility may also be increased.

### Brief Description of the Drawings

Fig. 1 illustrates a flow chart showing a fabrication method of a pocket-type photovoltaic backsheet according to the present invention,
Fig. 2 illustrates a process diagram showing the fabrication method of a pocket-type photovoltaic backsheet according to the present invention,
Fig. 3 illustrates a cross-sectional diagram showing modified examples of the pocket-type photovoltaic backsheet according to the present invention.
Fig. 4 illustrates the pocket-type photovoltaic backsheet and a photovoltaic module according to the present invention.

### * Description of reference numerals for main parts of the drawings *

M: Photovoltaic module F: Frame
BS: Backsheet
10: Thermal conductive member
20: Insulation film 21: Opening 23: Seal
30: Coating layer 40: Adhesive means
50: Carbon black layer 60: Heat radiating ceramic layer 70: Protection layer

### Best Mode for Carrying Out the Present Invention

Hereinafter, the fabrication method of a pocket-type photovoltaic backsheet and the pocket-type photovoltaic backsheet fabricated by the same, and the photovoltaic module equipped with the backsheet will be described in detail with reference to the accompanying drawings.

As definition of the terms used in this specification, a 'plate-like' does not have a limited thickness and has a significance including the concept of a general sheet or film, and
additionally, an 'exposed surface' refers to an external portion or external surface of each member, and
additionally, a 'laminated surface' refers to a side surface portion of a backsheet, which is configured of a lamination of each material.

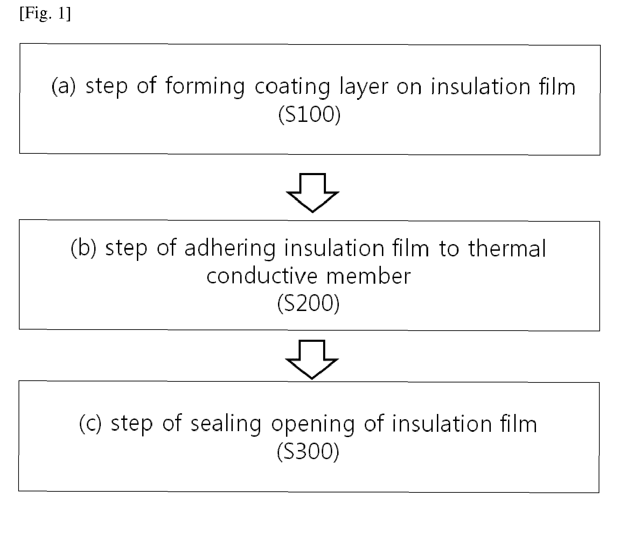

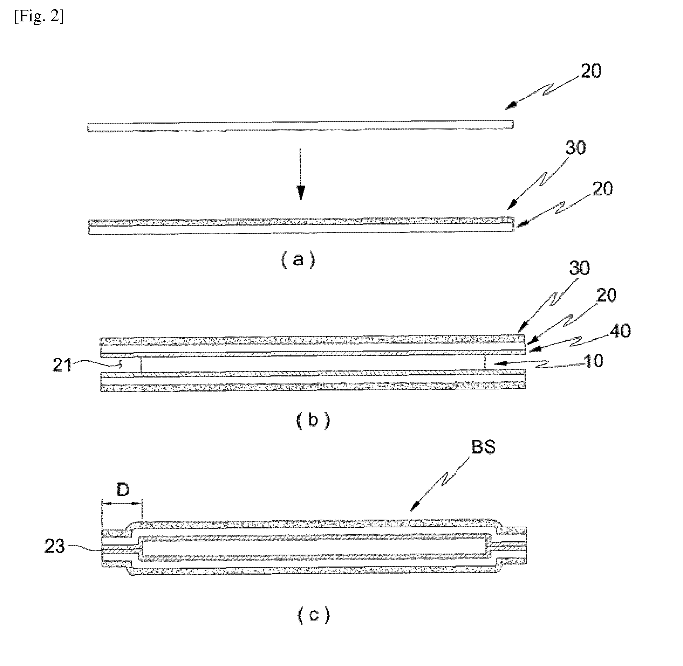

As shown in Fig. 1 and Fig. 2, the fabrication method of a pocket-type photovoltaic backsheet according to the present invention includes
(a) a step of forming a coating layer (30) on a portion of an exposed surface or an entire exposed surface of an insulation film (20);
(b) a step of adhering the insulation film (20) on both sides of a plate-like thermal conductive member (10); and
(c) a step of sealing an opening (21) of the insulation film (20), so as to form a pocket that is blocked from the outside (or outside environment).

As shown in Fig. 1 and Fig. 2, in the fabrication method of a pocket-type photovoltaic backsheet according to the present invention, the (a) step (S100) corresponds to a process of forming a thermal conductive coating layer (30) on an exposed surface of an insulation film (20).

And, the coating layer (30) is equipped with one or more functions selected from thermal conduction, heat radiation, weather resistance (or durability).

In the (a) step (S100), the coating layer (30) is formed by depositing thermal conductive (or heat radiating or weather resistant) coating on a portion of an exposed surface or an entire exposed surface of an insulation film (20),
at this point, the coating layer (30) is formed by being deposited on the insulation film (20), which is rolled, and, then, cut-off to a predetermined size,
or, after cutting-off the insulation film (20) itself to a predetermined size, the coating layer (30) is formed on an exposed surface of the insulation film (20).

First of all, the insulation film (20) is configured of one material among PET, PI PP, PE, BOPP, OPP, PVF, PVDF, TPE, ETFE, Aramid film and nylon, EVA, or a composite material obtained from the above, and
the insulation film (20) is fabricated by molding (or forming) the above-mentioned highly polymer substance to a thin film form.

Most particularly, since the insulation film (20), which is configured of a highly polymer substance, as described above, has an excellent withstanding voltage, the insulating portion is very unlikely to be damaged (or destroyed), thereby being advantageous in that the durability can be enhanced,

and, in light of the quality standard, this characteristic has the advantage of being capable of expanding the range of application to diverse fields requiring higher withstanding voltage.

Additionally, since the insulation film (20) has excellent heat resistance, not only can the effects of the insulation film being broken or destroyed (or damaged) be prevented, by being fabricated in the form of a thin film, the insulation film (20) can also enable the backsheet (BS) itself to be fabricated as a thin film.

Subsequently, the coating layer (30) ensures insulating performance and heat radiating performance of the backsheet (BS) and, also, enhances heat resistance and adhesive strength, and also allows the backsheet (BS) to be fabricated as a thin film.

In this case, the coating layer (30) is configured by using an organic or inorganic thermal conductive coating or an organic-inorganic composite hybrid thermal conductive coating,
and, this is to resolve the problems of mechanical strength and adhesive strength becoming weaker due to low surface energy and low molecular force of an organic polymeric substance, in case of using an organic polymeric substance as the coating layer.

First of all, the coating layer (30) uses an inorganic coating, which is configured of a metallic oxide, CNT, Silicon, and so on, such as alumina, titanium oxide, zirconia of the ceramic group, and, at this point, the inorganic coating has the advantage of having excellent heat resistance, chemical stability, heat conductivity, and insulation, and so on.

However, in case of using an inorganic coating, thin film fabrication becomes difficult due to its characteristics of being highly brittle, and, due to its disadvantage of not being processed with low temperature firing, an organic-inorganic composite hybrid thermal conductive coating, which corresponds to a combination of the inorganic coating and urethane, which is an organic substance material, or an organic chemical coating, such as polyester, acryl, and so on, may be alternatively adopted.

Therefore, the coating layer (30), which is configured of an organic-inorganic composite hybrid thermal conductive coating, yields excellent insulating performance and heat radiating performance, and radiation, and also yields excellent heat resistance and adhesive strength,
and, furthermore, since the coating layer (30) can be fabricated in a thin film, advantages of ensuring product reliability and enhancing product quality may be gained.

Meanwhile, as an alternative format of the inorganic coating or organic-inorganic composite hybrid thermal conductive coating, a ceramic coating including 1 type or more types selected from Al₂O₃, AlS, AlN, ZnO₂, TiO₂, SiO₂, TEOS, MTMS, ZrO₃, and MOS₂, may also be adopted, so as to ensure the insulating performance and the heat radiating performance.

Subsequently, as shown in Fig. 1 and Fig. 2, the (b) step (S200) in the fabrication method of a pocket-type photovoltaic backsheet (BS) according to the present invention corresponds to a process of closely adhering the insulation film (20) on both sides of the plate-like thermal conductive member (10).

In the (b) step (S200), a plate-like thermal conductive member (10) is prepared by being cut-off or cut-out, and, then, the heat conductive insulation film (20) is closely adhered thereto,
herein, such close adhesion process may be processed by having the insulation film (20) be closely adhered to both sides of the thermal conductive member (10), or by adhering the insulation film (20) having adhesive deposited on the entire surface of the insulation film (20) to both sides of the thermal conductive member (10), during the process of sealing an opening (21) of the insulation film (20) in the (c) step (S300), which will be performed as described below.

However, in order to increase the level of adhesion between the thermal conductive member (10) and the insulation film (20), the latter method will be more preferable,
and, a transparent adhesive film of EVA, acryl, urethane group having thermal conductivity, or an adhesive coating may be adopted as the adhesive being deposited on the insulation film (20).

Alternatively, by using a thermo-plastic non-solvent adhesive as the adhesive, the problem of consuming at least 5∼7 days until the conventional fabrication of the end product may be resolved, thereby allowing fabrication to be performed by having the thermal conductive member, which is located in the middle, simultaneously adhered to insulation films located on upper and lower surfaces of the thermal conductive member, without requiring any fermentation.

More specifically, in the conventional photovoltaic backsheet fabrication process, when a 3-layer type is being fabricated, a middle member is adhered to one side of another member, and, after a fermentation process in order to remove remaining solvent, another insulation member is adhered to the opposite side, and, then, another fermentation process is carried out, and, since solvent adhesive is mostly used, at least 5∼7 days were consumed up to the fabrication of the end product.

However, in the present invention, fabrication is performed by simultaneously adhering the plate-like thermal conductive member, which is placed in the middle, and insulation films of its upper and lower surfaces to one another by using a thermo-plastic non-solvent adhesive as the adhesive, and by eliminating the need for fermentation.

Additionally, in a more specific method of forming a pocket, a thermo-plastic adhesive is deposited in advance on an insulation film (20), which is wider than the thermal conductive member (10), and, then, this is positioned on upper and lower surfaces of the thermal conductive member (10), and the thermal conductive member is processed along the process direction, and the process is proceeded up to the insulation film along the same direction, and, then, after cutting-off the thermal conductive member, upper and lower surfaces of the insulation film are pressed by a heating roller, thereby forming (or fabricating) a pocket-type backsheet.

Moreover, the thermal conductive member is configured of any one material among aluminum, copper, brass, steel plate and stainless steel, and graphite, or a composite material obtained from the above, each having excellent thermal conductivity,
and, although the thermal conductive member (10) is fabricated in the form of a thin film, since the above-described materials have excellent rigidity and heat resistance equal to or more than a predetermined level, deformation of the material caused by thermal stress may be prevented.

Subsequently, in case the adhesive, *i.e.,* a film-type adhesion means (40) is adopted, the adhesion means (40) is aligned on both surfaces of the thermal conductive member (10), and, after positioning the insulation film (20) on the exposed surface of the adhesion means (40), a predetermined level of thermal pressure is applied, thereby performing the laminating process.

In this case, after laminating the thin film-type thermal conductive member (10) and adhesion means (40) by using the difference in thermal expansion coefficient and cooling rate, during the cooling process, due to a difference in the cooling rate between the thermal conductive member (10) and the adhesion means (40), the thermal conductive member (10) may become bent, and

since the materials being adopted as the insulation film (20) have similar thermal expansion coefficients and cooling rates as the adhesion means (40), after performing the laminating process, during the cooling process, this problem may be resolved by having the insulation film (20) minimize the difference in the cooling rate between the thermal conductive member (10) and adhesion means (40), so as to prevent flexural deformation of the thermal conductive member (10), thereby being capable of uniformly maintaining the quality of the product.

In the fabrication method of a pocket-type photovoltaic backsheet according to the present invention, as shown in Fig. 1 and Fig. 2, the (c) step (S300) corresponds to a process of forming a pocket blocking the outside environment by sealing the opening (21) of the insulation film (20), after performing the (b) step (S200).

In the (c) step (S300), the opening (21) of the insulation film (20) is sealed, and
at this point, in case of single sheets of the insulation films are being positioned on both sides of the thermal conductive member (10), when it is assumed that the backsheet (BS) is configured to have a rectangular shape, the number of openings (21) of the insulation film (20) may be equal to 4 spots, and,
alternatively, in case the insulation film (20) is sealed in advance in the form of a pocket, so as to maintain (or retain) the opening in order to introduce (or insert) the thermal conductive member (10), the number of openings (21) may be equal to 1 spot.

In the present invention, when the opening (21) of the insulation film (20) is sealed, a seal (23) is formed on the sealed portion, thereby forming a pocket that is blocked from the outside (or outside environment), and, due to this pocket, the thermal conductive member (10) is completely sealed and blocked from external contact.

By doing so, humidity or impurities (or foreign material) may be prevented from being introduced to the backsheet (BS), and
additionally, since the laminated surface between the thermal conductive member (10) and the insulation film (20) is not exposed to the outside, as in the related art, and since contact with the ambient air, humidity, and so on is blocked, the peeling of the thermal conductive member (10) and the insulation film (20) may be prevented.

Additionally, since the insulation film (20) seals the thermal conductive member (10), so as to prevent the side surface of the thermal conductive member (10) from being exposed to the outside, as in the related art, the insulating performance may be realized more perfectly.

Meanwhile, when the photovoltaic module is fabricated by using the conventional method by using a metallic or graphite material, through which gas cannot be penetrated, as the plate-like thermal conductive member (10) without any edge, since the photovoltaic module is installed on the outside, and since gas that is generated from the EVA layer of the module cannot be discharged to the outside, in the long term, a critical downside of other layers of the photovoltaic module and the backsheet being inevitably peeled may occur.

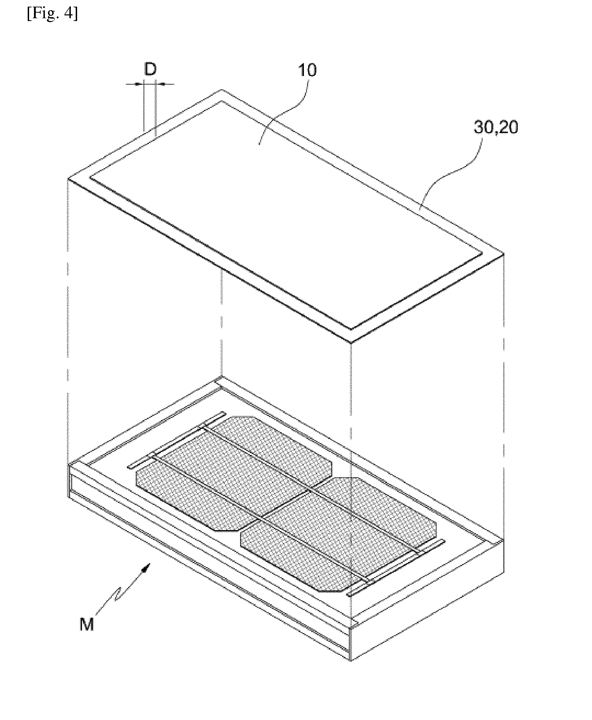

However, in the present invention, by performing (a) step (S100) ∼ (c) step (S300), the size of the plate-like thermal conductive member and the size of the insulation film may be freely designed (being configured as a pocket-type, the size of the insulation film is larger than the size of the plate-like thermal conductive member), and, accordingly, a width of an aperture (or gap) (D), which is formed due to the difference in size between the insulation film and the plate-like thermal conductive member, may also be freely designed (*ref.* Fig. 2),
and, since the aperture (D) can be designed in accordance with the photovoltaic module,
diverse forms of paths enabling gas, which is generated from the EVA layer within the photovoltaic module, to be discharged are provided in the photovoltaic module (M), the problem of the peeling of the backsheet is completely resolved (*ref.* Fig. 2 and Fig. 4)

Additionally, due to the pocket-type format, since the thermal conductive member is not aligned in the seal (23), and since only pure insulator is remained at the edge, leakage current, which used to leak through an aluminum frame of the photovoltaic module, is eventually blocked, thereby enhancing the insulating capability of the photovoltaic module.

Moreover, although it is not shown in the accompanying drawings, in the fabrication method of a pocket-type photovoltaic backsheet (BS) according to the present invention,
although it is preferable to perform the (a) step in the earliest time order,
whenever required, the order of the (a) step and the (b) step may be alternated, so that the insulation film can be adhered to the thermal conductive member by performing the (b) step, and so that a thermal conductive coating layer is formed on the insulation film afterwards by performing the (a) step.

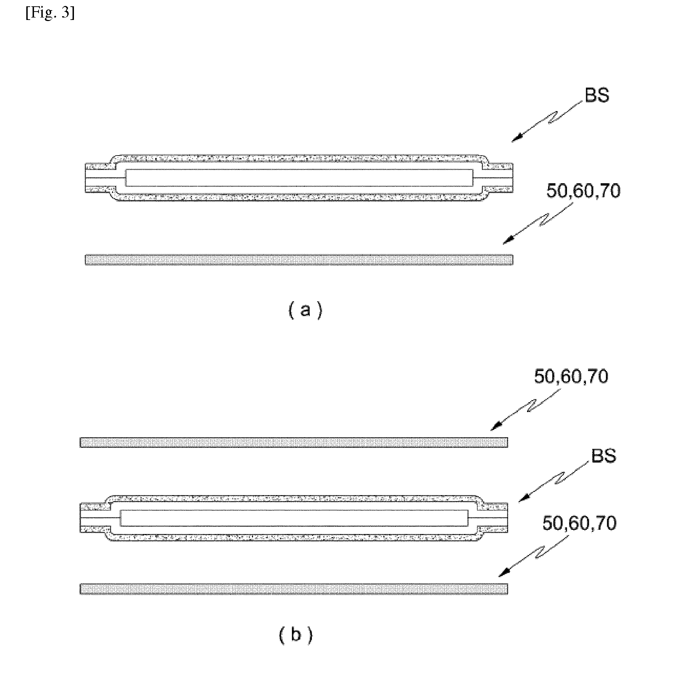

Furthermore, as shown in Fig. 3, after performing the (b) step according to the present invention, a carbon block layer (50) is further formed on the exposed surface of the coating layer (30), and,
herein, the carbon black layer (50) enhances the heat radiation efficiency by increasing the thermal radiation performance.

The above-described carbon black layer (50) is formed by depositing carbon block resin, and,
additionally, since the carbon black layer (50) has excellent thermal radiation, *i.e.,* heat shear-rate, by discharging the conductive heat, which is transferred from the coating layer (30), more quickly to the ambient air, the heat radiation efficiency is maximized.

Moreover, as shown in Fig. 3, after performing the (b) step according to the present invention, a heat radiation ceramic layer or heat radiation coating layer (60) is further formed on the exposed surface of the coating layer (30), and,

herein, the heat radiation ceramic layer (or heat radiation coating layer) (60) is configured of 1 or more types selected from 1 type or more of a metallic ceramic material, which is selected from a group consisting of alumina, titanium oxide, and zirconia, and
1 type or more of a non-metallic ceramic material, which is selected from a group consisting of organosilane, non-organosilane, silane coupling agent, and CNT.

Accordingly, by efficiently discharging the conductive heat, which is being transferred by the thermal conductive coating layer (30), to the outside, the heat radiation ceramic layer (or heat radiation coating layer) (60) may be capable of enhancing the heat radiation efficiency and a power generation amount of the photovoltaic module, which is generated by the heat radiation efficiency.

Additionally, as shown in Fig. 3, after performing the (b) step, a protection layer (70) is further formed on the exposed surface of the coating layer (30), and,
herein, a material, such as ceramic, fluororesin (or fluoride resin), is used for the protection layer (70), and,
at this point, due to its excellent properties of durability (or weather resistance) and corrosion resistance, the protection layer (70) not only yields an excellent effect of blocking ultraviolet rays but also enhances surface protection and insulation performance of the backsheet (BS).

Meanwhile, although it is not shown in the accompanying drawings, the carbon black layer, the heat radiation ceramic layer (or heat radiation coating layer), and the protection layer may be selectively adopted as a single-layer form or a multi-layer form of 2 or more layers, and
depending upon the respective functionality, the lamination order may be applied to the exposed surface of the coating layer, or, after the (a) step (S100), the lamination order may be applied to the exposed surface of the insulation film, and,
additionally, as shown in Fig. 3, each of the layers may also be placed on a portion of the exposed surface of the coating layer (*ref.* (a) of Fig. 3) or on the entire exposed surface of the coating layer (*ref.* (b) of Fig. 3).

Moreover, in case the carbon black layer and the heat radiation ceramic layer (or heat radiation coating layer) are selectively or collectively adopted, it is preferable that the protection layer is formed on an exposed surface of a layer located on the outermost side.

As shown in Fig. 1 and Fig. 2, a pocket-type photovoltaic backsheet according to the present invention is configured by comprising
an insulation film (20); a coating layer (30) formed on a portion or all of an exposed surface of the insulation film (20); and a plate-like thermal conductive member being adhered to both sides of the insulation film (20),
wherein an opening (21) of the insulation film (20) is sealed to form a pocket blocking the outside (or outside environment).

Additionally, in order to form a pocket blocking the outside (or outside environment), by forming a seal (23) after sealing an opening (21) by using a method of performing thermal pressure bonding on the opening (21) of the insulation film (20), so as to perform fusion, the thermal conductive member (10) is sealed by the insulation film (20), thereby being completely blocked from the outside environment.

Furthermore, since each element configuring the backsheet according to the present invention has the same functions and capability (or performance), which are described above, the detailed description of the same will be omitted in order to avoid repeated and overlapping description.

Additionally, as shown in Fig. 3, in the backsheet (BS), which is fabricated by using the fabrication method according to the present invention, as required, the carbon black layer (50), the heat radiation ceramic layer (or heat radiation coating layer) (60), and the protection layer (70) may be adopted as a single layer or as multiple layers, and
since each of the respective functions is identical to the functions that are described above, the detailed description of the same will be omitted.

Moreover, the carbon black layer, the heat radiation ceramic layer, and the protection layer may be adopted after performing the (b) step, and as shown in the accompanying Fig. 3, each of the layers may be adopted after performing the (c) step, and, additionally, when considering the processing convenience for forming each layer, it is preferable that each of the layers is formed by being adhered or deposited after the backsheet is sealed, *i.e.,* after performing the (c) step.

Subsequently, Fig. 4 illustrates a rear side surface of the photovoltaic module according to the present invention, wherein a status before and after mounting the backsheet (BS) is shown.

With the exception for the backsheet (BS) structure, each element of the photovoltaic module is identical to each element of the conventional photovoltaic module, and therefore, detailed description of the same will be omitted. And, the backsheet (BS) is equipped to (or mounted on) the inside of the frame (F) of the photovoltaic module (M), and since the photovoltaic module is equipped with a backsheet (BS) having the above-described structure, or with a backsheet (BS), which is completed by performing the above-described fabrication process, the safety of the photovoltaic module may be anticipated, and enhanced quality may be expected.

In the description of the fabrication method of a pocket-type photovoltaic backsheet and the pocket-type photovoltaic backsheet fabricated by the same, and the photovoltaic module equipped with the backsheet according to the present invention, which is provided above with reference to the accompanying drawings, although the description is provided based upon a specific form (or shape) and a specific direction, diverse variations and modifications may be made to the present invention by anyone skilled in the art, and it should be understood and interpreted that such variations and modifications are included in the spirit and scope of the present invention.

## Claims

1. A fabrication method of a pocket-type photovoltaic backsheet comprising:
(a) a step of forming a coating layer having one or more functions selected from thermal conduction, radiation, and durability on a portion of an exposed surface or an entire exposed surface of an insulation film;
(b) a step of adhering the insulation film having a size that is larger than a thermal conductive member on both sides of a plate-like thermal conductive member; and
(c) a step of sealing an opening of the insulation film, wherein the opening is formed by placing the insulation film having a size larger than the thermal conductive member on both sides of the thermal conductive member, so as to form a pocket blocking an outside environment.

2. The method of claim 1, wherein the adhesion of the thermal conductive member and the insulation film of the (b) step is performed by an adhesion means.

3. The method of claim 1 or claim 2, wherein the coating layer is formed by using an organic or inorganic thermal conductive coating or an organic-inorganic composite hybrid thermal conductive coating.

4. The method of claim 1 or claim 2, wherein the insulation film is configured of one material among PET, PI PP, PE, BOPP, OPP, PVF, PVDF, TPE, ETFE, Aramid film and nylon, EVA, or a composite material obtained from the above.

5. The method of claim 1 or claim 2, wherein the thermal conductive member is configured of any one material among aluminum, copper, brass, steel plate and stainless steel, and graphite, or a composite material obtained from the above.

6. The method of claim 1 or claim 2, wherein, after the (b) step, a heat radiation ceramic layer or a heat radiation coating layer is further formed on an exposed surface of the coating layer.

7. The method of claim 1 or claim 2, wherein, after the (b) step, a protection layer is further formed on an exposed surface of the coating layer.

8. A pocket-type photovoltaic backsheet, comprising:
an insulation film;
a coating layer having one or more functions selected from thermal conduction, radiation, and durability formed on a portion of an exposed surface or an entire exposed surface of the insulation film; and
a plate-like thermal conductive member being adhered to both sides of the insulation film,
wherein the insulation film is formed to have a size larger than the thermal conductive member, and wherein an opening of the insulation film, which is formed accordingly, is sealed, so as to form a pocket blocking an outside environment.

9. As a photovoltaic module equipped with a backsheet on its lower surface, the photovoltaic module is equipped with a pocket-type photovoltaic backsheet, wherein the backsheet is configured according to claim 8.
